## Europäisches Patentamt
## European Patent Office
## Office européen des brevets

(19)

(11) Numéro de publication: **0 094 869**
**B1**

(12)
# FASCICULE DE BREVET EUROPEEN

(45) Date de publication du fascicule du brevet: 13.11.85

(51) Int. Cl.⁴: **H 01 L 23/04**, H 01 L 23/10, H 01 L 21/50

(21) Numéro de dépôt: **83400928.4**

(22) Date de dépôt: **06.05.83**

(54) Boîtier d'encapsulation de circuit microélectronique à haute dissipation thermique, et son procédé de fabrication.

(30) Priorité: **07.05.82 FR 8207990**

(43) Date de publication de la demande: **23.11.83 Bulletin 83/47**

(45) Mention de la délivrance du brevet: **13.11.85 Bulletin 85/46**

(84) Etats contractants désignés: **DE GB IT**

(56) Documents cités: **FR - A - 2 436 497**

(73) Titulaire: **THOMSON-CSF, 173, Boulevard Haussmann, F-75379 Paris Cedex 08 (FR)**

(72) Inventeur: **Thirion, Christian, THOMSON-CSF SCPI 173, bld Haussmann, F-75379 Paris Cedex 08 (FR)**

(74) Mandataire: **Taboureau, James et al, THOMSON-CSF SCPI 173, Bld Haussmann, F-75379 Paris Cedex 08 (FR)**

BUNDESDRUCKEREI BERLIN

## Description

La présente invention concerne un boîtier d'encapsulation pour circuit hybride, à dissipation thermique, et connexions d'accès extérieur serties par perles de verre. Un tel boîtier est muni d'un fond métallique afin de dissiper la chaleur au cours du fonctionnement du circuit hybride. L'invention concerne également le procédé de réalisation de boîtier selon l'invention.

Un boîtier d'encapsulation selon le préambule de la revendication 1 est connu du FR-A-2 436 497.

Les circuits hybrides sont réalisés sur un substrat isolant, très généralement de type céramique, tel que oxyde de béryllium ou alumine.

Les conditions d'environnement imposées aux circuits hybrides font qu'ils sont fréquemment encapsulés dans un boîtier métallique.

Dans le cas où le circuit possède un élément de puissance, c'est-à-dire dans le cas où le circuit hybride dégage de la chaleur; il est préférable que le fond de boîtier soit un bon conducteur thermique et de préférence en cuivre.

Un boîtier d'encapsulation dont le fond est en cuivre est assez couramment réalisé par usinage dans un bloc de cuivre. Les connexions d'accès extérieur enverrées dans un tube métallique sont reportées par brasure du tube métallique sur le boîtier, le cuivre étant difficilement scellable par un verre. Ce procédé est coûteux.

Un autre procédé consiste à faire l'assemblage par brasure tendre d'un cadre métallique préalablement enverré et d'un fond en cuivre. Dans certains cas une brasure tendre peut être incompatible avec la brasure utilisée pour rapporter des éléments sur le circuit hybride.

Selon l'invention, un boîtier d'encapsulation d'un circuit hybride de puissance, dissipant de la chaleur, est constitué par un cadre métallique portant les connexions d'accès fixées par perles de verre, ce cadre étant soudé sur le fond métallique du boîtier de préférence en cuivre par une brasure à haute température, dont la température de fusion est du même ordre de grandeur, à 100° près, que celle du verre de fixation des connexions. Ainsi, il n'y a plus de problèmes d'incompatibilité entre la brasure du cadre et la soudure de report des composants; en outre les deux opérations de brasure du cadre sur le fond de boîtier métallique et de fixation de connexions d'accès par perles de verre ont lieu simultanément dans le même intervalle de température.

De façon plus précise, l'invention concerne un boîtier d'encapsulation de circuit microélectronique à haute dissipation thermique, comportant un fond métallique et bon conducteur thermique, un cadre métallique, traversé par une pluralité de connexions d'accès extérieur isolées par des perles de verre, le cadre étant fixé sur le fond de boîtier au moyen d'une brasure, ce boîtier d'encapsulation étant caractérisé en ce que la brasure est du type dit haute température et dont la plage de fusion se trouve dans la plage de température de ramollissement du verre des perles de scellement des connexions extérieures.

L'invention sera mieux comprise par la description d'un exemple d'application, lequel s'appuie sur les figures annexées qui représentent:
— figure 1 boîtier d'encapsulation d'un circuit hybride, selon l'art connu,
— figure 2 vue en coupe d'un boîtier d'encapsulation, ayant la structure de l'invention.

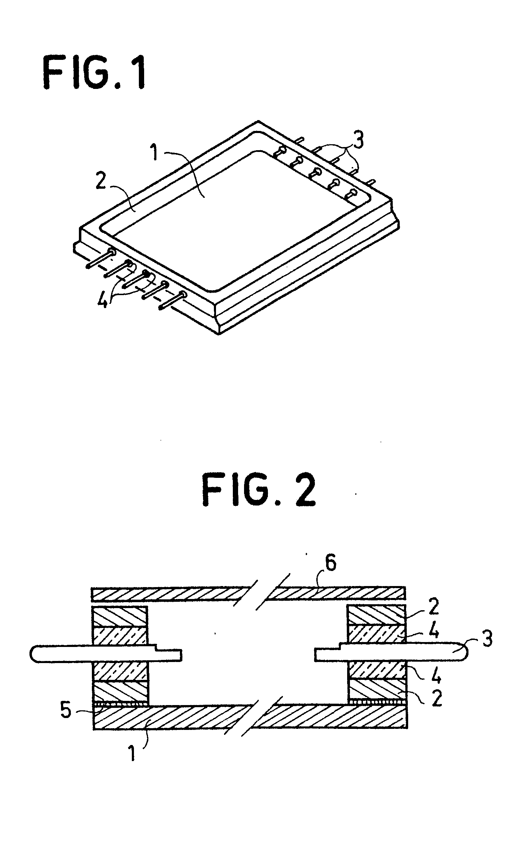

La figure 1 représente un modèle, parmi d'autres, de boîtier d'encapsulation de circuits hybrides. Le couvercle du boîtier en a été ôté de façon à laisser voir sa structure interne. La forme du boîtier est indifférente et peut tout aussi bien être carrée ou rectangulaire.

Un boîtier d'encapsulation de circuit hybride de puissance comporte un fonde de boîtier 1, et un cadre 2 correspondant à l'épaisseur du circuit hybride à encapsuler. Si le circuit hybride dissipe de la puissance, il est alors nécessaire que le circuit hybride soit réalisé sur une fine plaquette de céramique de façon à ne pas s'opposer à la transmission calorifique. La plaquette céramique est ensuite rapportée sur un fond de boîtier qui est métallique et bon conducteur thermique. Parmi les différents métaux possibles, le cuivre est celui qui est préféré.

Un tel boîtier peut être réalisé de deux façons différentes. Un premier procédé consiste à usiner dans un bloc de métal suffisamment épais une cavité, de telle sorte qu'apparaisse un cadre 2 solidaire d'un fond de boîtier 1, puisque ces deux parties du boîtier sont usinées dans un même bloc. Mais ce procédé est coûteux et peu industriel. Un second procédé consiste à découper un fond de boîtier 1 dans une plaque d'épaisseur convenable et à rapporter sur ce fond de boîtier plat un cadre 2, par des moyens appropriés: c'est la méthode la plus couramment utilisée actuellement.

Un tel boîtier comporte nécessairement des connexions d'accès extérieur 3. Celles-ci peuvent être rapportées par l'intermédiaire de joints de verre isolant dans le fond de boîtier 1, mais cette solution, bien qu'elle appartienne au domaine de l'invention, n'est pas intéressante: en effet, si le circuit hybride considéré dégage de la chaleur par l'intermédiaire du fond de boîtier 1, celui-ci est préférentiellement accolé à un radiateur ou à tout autre moyen pour évacuer la chaleur dissipée. Par conséquent la solution la plus logique et la plus industrielle consiste à insérer les connexions d'accès extérieur 3 dans le cadre. Si le cadre est en céramique il n'y a pas de problèmes d'isolation entre les connexions d'accès extérieur 3, mais par contre il y a des problèmes d'adaptation entre les coefficients de dilatation du fond de boîtier 1 et du cadre 2: c'est pourquoi la meilleure adaptation possible consiste à réaliser un boîtier métallique, le fond de boîtier, le cadre, et le couvercle ayant des coefficients de dilatation voisins.

Un fond de boîtier 1 et un cadre 2, s'ils sont respectivement en cuivre et en acier par exemple, ce qui est la solution préférée, peuvent être soudés l'un sur l'autre au moyen d'une soudure tendre. Cependant la réalisation d'un tel boîtier suppose deux opérations de montage: d'abord la fixation des connexions externes 3 dans le cadre 2 par l'intermédiaire de perles de verre 4, opération qui se fait à la température de fusion du verre aux environs de 800 à 900°C. Ensuite la fixation par soudure du fond de boîtier 1 sur le cadre 2 par une soudure tendre aux environs de 200 à 300°C selon l'alliage utilisé.

Un tel montage a cependant un inconvénient, car la soudure tendre utilisée pour le montage du boîtier peut dans certains cas poser des problèmes de compatibilité avec la brasure tendre de type plomb-étain utilisé pour report d'éléments dans le boîtier, au cas où ces deux types de soudure viendraient au contact l'une de l'autre. En outre, la fixation du cadre sur fond de boîtier par une soudure tendre ne permet pas certaines opérations ultérieures telles que le report de composants par des brasures nécessitant une température de 400°, comme par exemple l'or-silicium, l'or-germanium.

L'invention consiste à remplacer la soudure tendre classique par une brasure à haute température, préférentiellement choisie de telle façon que les opérations de montage du cadre sur le fond de boîtier et de montage des connexions extérieures dans les perles de verre se fassent simultanément et dans une même zône de température.

La figure 2 représente une vue en coupe d'un boîtier selon l'invention.

Ce boîtier est constitué d'un fond de boîtier 1, métallique, et d'un couvercle 6, métallique lui aussi, espacés par un cadre qui apparait en coupe sur les parties droite et gauche de la figure. La cadre 2 comporte une série d'orifices dans lesquels sont mis en place des bornes d'accès extérieur 3, centrées et isolées par rapport au cadre métallique 2 par de la poudre de verre, qui, après frittage, donne les perles de verre isolantes 4. La soudure du cadre 2 sur le fond de boîtier 1 se fait au moyen d'une brasure à haute température 5 de type argent-manganèse ou argent-cuivre ou or-nickel.

Le choix d'une brasure à haute température, dont la température de fusion est comprise entre 700 et 900°C, c'est-à-dire à une température voisine de la température de fusion du verre, permet de réaliser simultanément la fixation du cadre sur le fond de boîtier et la fixation des connexions d'accès extérieur 3 dans le cadre par l'intermédiaire des perles de verre. Ainsi, la réalisation d'un tel boîtier est une opération beaucoup plus simple que les opérations précédentes, et en outre il n'y a plus de problèmes d'incompatibilité entre la soudure du boitier et la soudure de report des composants dans le boîtier.

Selon les spécifications demandées, la brasure à haute température 5, peut être à titre d'exemple, un alliage argent-cuivre dans la proportion de 72—28% qui fond entre 700 et 900°, ou bien alliage argent-manganèse dans la proportion 85—15% qui fond à une température supérieure ou égale à 900°C ou un alliage or-nickel 82—12% qui fond à 950°C. L'important est que l'alliage de brasure à haute température ait une plage de fusion qui se trouve à l'intérieur de la plage de viscosité du verre à l'état pâteux, de façon à ce que les deux opérations puissent avoir lieu simultanément.

Lorsque le circuit hybride est monté à l'intérieur du boîtier selon l'invention, le couvercle 6, qui est lui aussi préférentiellement métallique peut être rapporté sur le cadre 2 soit par une préforme or-étain classique, soit par soudure électrique.

L'invention qui a été exposée en s'appuyant sur un modéle de boîtier pour circuit hybride concerne de façon plus générale des boîtiers d'encapsulation de composants électroniques dont les formes peuvent être différentes de celles qui ont été citées.

**Revendications**

1. Boitîer d'encapsulation de circuit microélectronique à haute dissipation thermique, comportant un fond (1) métallique et bon conducteur thermique, un cadre (2) métallique, traversé par une pluralité de connexions d'accès extérieur (3) isolées par des perles de verre (4), le cadre (2) étant fixé sur le fond de boîtier (1) au moyen d'une brasure (5), ce boîtier d'encapsulation étant caractérisé en ce que la brasure est du type dit haute température et dont la plage de fusion se trouve dans la plage de température de ramollissement du verre des perles (4) de scellement des connexions extérieures (3).

2. Boîtier d'encapsulation de circuit microélectronique, selon la revendication 1, caractérisé en ce que le fond de boîtier (1) est en cuivre et le cadre (2) est en acier.

3. Procédé de fabrication d'un boîtier d'encapsulation de circuit microélectronique selon la revendication 1, caractérisé en ce que le scellement des connexions d'accès extérieur (3) dans le cadre (2) au moyen de perles de verre (4) et la brasure (5) du fond de boîtier (1) sur le cadre (2), par une brasure haute température, se font au cours de la même opération.

4. Procédé de fabrication selon la revendication 3, caractérisé en ce que la brasure est du type Ag-Cu(72/28) ou Ag-Mn(85/15) ou Au-Ni(82/18).

**Patentansprüche**

1. Gehäusekapsel für einen Mikroelektronik-Schaltkreis großer Wärmeabfuhr, mit einem gut wärmeleitenden Metallboden (1), einem Metallrahmen (2), der von zahlreichen durch Glasperlen (4) isolierten Außenanschlußdrähten (3) durchquert wird und der durch Lötung (5) auf dem Gehäuseboden (1) befestigt ist, dadurch gekennzeichnet, daß es sich um eine Hochtemperaturlötung handelt, deren Schmelztemperatur im Bereich der Erweichungstemperatur des Glases der Perlen zum Einsiegeln der Außenanschlüsse (3) liegt.

2. Gehäusekapsel nach Anspruch 1, dadurch gekennzeichnet, daß der Gehäuseboden (1) aus Kupfer und der Rahmen (2) aus Stahl ist.

3. Verfahren zur Herstellung einer Gehäusekapsel nach Anspruch 1, dadurch gekennzeichnet, daß das Einsiegeln der Außenanschlußdrähte (3) in den Rahmen (2) mit Hilfe von Glasperlen (4) und die Verlötung (5) des Gehäusebodens (1) auf dem Rahmen (2) mit Hilfe einer Hochtemperaturlötung zugleich erfolgen.

4. Herstellungsverfahren nach Anspruch 3, dadurch gekennzeichnet, daß das Lötmaterial vom Typ Ag-Cu(72/28) oder Ag-Mn(85/15) oder Au-Ni(82/18) ist.

**Claims**

1. An encapsulation housing for a microelectronic circuit with high heat dissipation, comprising a metal frame (2) which is traversed by a plurality of external acces connections (3) insulated by glass beads, and which is attached to the base (1) of the housing by means of a brazing (5), characterized in that the brazing is of the high temperature type and its fusion range is comprised in the range of the squatting temperature of the glass of the beads (4) for sealing the external connections.

2. An encapsulation housing according to claim 1, characterized in that the base (1) of the housing is made of copper and the frame (2) is made of steel.

3. A method for manufacturing an ecapsulation housing for a microelectronic circuit according to claim 1, characterized in that the sealing of the external access connections (3) in the frame (2) via glass beads (4) and the brazing (5) of the base (1) of the housing to the frame (2) by a high temperature brazing operation take place during the same phase of manufacturing.

4. A method according to claim 3, characterized in that the brazing is of the type Ag-Cu(72/28) or Ag-Mn(85/15) or Au-Ni(82/18).

# FIG.1

# FIG. 2